# EUROPEAN PATENT SPECIFICATION

(11) **EP 0 981 054 B1**
(45) Date of publication and mention of the grant of the patent: **30.08.2006**
(21) Application number: 99115116.8
(22) Date of filing: 10.08.1999
(51) Int. Cl.: G01R 23/16, G01R 23/163

(54) **Wide band signal analyzer**
Breitband-Signalanalysator
Analyseur de signal à large bande

(30) Priority: 10.08.1998 JP 22625498; 24.08.1998 JP 23683898
(43) Date of publication of application: 23.02.2000
(73) Proprietor: Tektronix Japan, Ltd., Shinagawa-ku, Tokyo 141 (JP)
(72) Inventor: Nara, Akira, Kodaira-shi, Tokyo 187-0032 (JP)
(74) Representative: Molyneaux, Martyn William

(56) References cited:
- EP-A- 0 338 333
- EP-A- 0 439 157
- US-A- 5 530 373
- US-A- 5 731 699
- ELO M A: "DECT MEASUREMENTS WITH A MICROWAVE SPECTRUM ANALYZER" HEWLETT-PACKARD JOURNAL,US,HEWLETT-PACKARD CO. PALO ALTO, vol. 44, no. 6, 1 December 1993 (1993-12-01), pages 98-106, XP000422724
- MCTIGUE M T ET AL: "AN 8-GIGASAMPLE-PER-SECOND, 8-BIT DATA ACQUISITION SYSTEM FOR A SAMPLING DIGITAL OSCILLOSCOPE" HEWLETT-PACKARD JOURNAL,US,HEWLETT-PACKARD CO. PALO ALTO, vol. 44, no. 5, 1 October 1993 (1993-10-01), pages 11-23, XP000403447

## Description

### Field of the Invention

The present invention relates to a wide band signal analyzer, especially, to a wide band signal analyzer suitable for analyzing the frequency domain of a signal under test.

### Background of the Invention

ELO M A: "Dect Measurements with a Microwave Spectrum analyzer" Hewlett-Packard Journal, US, Hewlett-Packard Co. Palo Alto, vol. 44, no. 6, 1 December 1993 (1993-12-01), pages 98-106, XP000422724 discloses a spectrum analyser for making Digital European Cordless Telecommunications (DECT) measurements using a microwave spectrum analyser in which a signal under test is down-converted and DECT demodulated for time-gating. The time-gate permits the ability to switch the signal path of the analyser so only selected time intervals of the signal are measured.

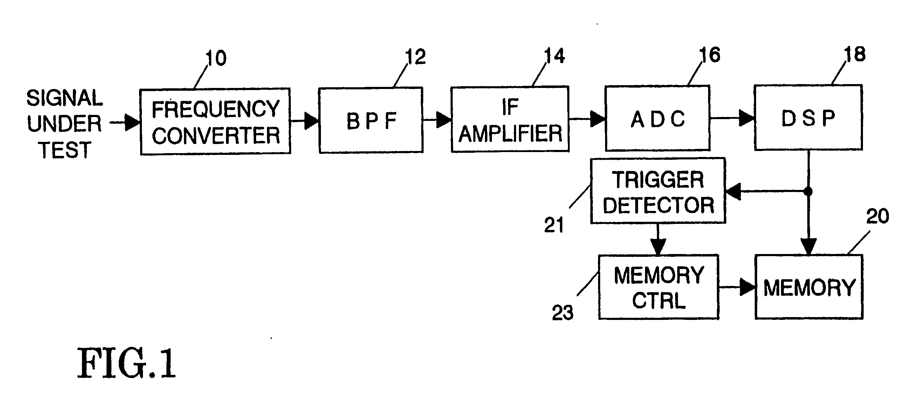

Fig. 1 shows a schematic block diagram of a conventional signal analyzer for analyzing the frequency domain of a signal under test. A frequency converter 10 which has a mixer and a local oscillator etc. converts a signal under test into an IF (Intermediate Frequency) signal. A band pass filter (BPF) 12 makes the IF signal have a suitable bandwidth. An IF amplifier 14 amplifies the output signal of the BPF 12 and an analog to digital converter (ADC) 16 converts it into a digital signal. A digital signal processor (DSP) 18 transforms the output signal of the ADC 16 into the frequency domain data by the Fast Fourier Transformation (FFT) process. A memory 20 sequentially stores the frequency domain data.

A trigger detector 21 detects whether the frequency domain data satisfies a predetermined trigger condition or not. That is, the trigger detector 21 compares the data set as the trigger condition with the frequency domain data of the signal under test and generates a trigger signal if the condition is satisfied. The data of the trigger condition is decided like that an operator specifies a zone in a measuring region on a display screen (not shown) as the trigger condition, on which the horizontal and vertical axes indicate frequency and amplitude, respectively.

When the trigger condition is satisfied, a memory controller 23 controls the storage operation of the memory 20 according to the trigger signal generation. In more detail, it can control the time up to the stop of the storage operation of the memory 20 after the time of the trigger generation. If the memory 20 stops the storage operation soon from the trigger signal generation, it stores the data up to the time of the trigger signal generation. This operation provides a pre-trigger function. On the other hand, if the memory 20 stops the storage operation after continuing the storage for some period from the trigger signal generation, it stores the data mainly after the time of the trigger signal generation. This provides a post-trigger function. The data stored in the memory 20 in such a way as described above are displayed on a suitable display like a cathode ray tube or a liquid crystal display etc. for the frequency domain analysis of the signal.

It is recently desired to make the frequency span of the signal under test wider because a communication system has come to use wider band and the instruments operate at higher speeds than before. It is, however, difficult for the conventional signal analyzer as shown in Fig. 1 to realize the wider band analysis. This is why to make the bandwidth of the band pass filter wider requires to make the bandwidth of the IF amplifier wider and the sampling frequency of the ADC higher. Then it is also required to make the operation speed of the DSP, the data transfer rate and the operation speed of the memory higher. These make it sensitive to disturbance or noise etc. and the spurious characteristics are worse. Besides, these pop the cost. Of course, it is impossible to realize the event trigger functions as described above for the wider frequency measurement.

Therefore, it is an object of the present invention to provide a new type signal analyzer at low cost with controlling the character degradation because of making the frequency band wider.

It is a further object of the present invention to provide a signal analyzer at low cost with useful event trigger functions for the signal measurement of the wide band frequency.

### Summary of the Invention

To solve this object, the present invention provides a wide band analyzer as specified in claim 1. Preferred embodiments of the invention are described in the subclaims.

The present invention provides a wide band signal analyzer suitable for analyzing the frequency domain of a signal under test at low cost with controlling the characteristics degradation.

A signal conversion means converts a signal under test into an intermediate frequency signal. A narrow band signal processing means receives the intermediate frequency signal for producing a first digital signal representing a specific frequency band of the intermediate frequency signal. The narrow band signal processing means has a usual configuration similar to the conventional one and is used for measuring the narrow band side.

This controls noise caused by the bandwidth wider and spurious characteristics degradation at the minimum.

A wide band signal processing means receives the intermediate frequency signal for producing a second digital signal representing a wider frequency band including said specific frequency band of the intermediate frequency signal. The optimum devices can be selected for both the narrow and wide signal processing means that provides an advantage from technical and economical viewpoints.

A decelerating means decelerates the transfer rate of the second digital data so that the following devices are not required in the high speed operation. A selecting means selects the first digital signal or the output signal of the decelerating means. A processing means processes the output signal of the selecting means by some process such as the FFT process. A memory means stores the processed output of the processing means. The data in the memory means is used for displaying the measurement result or another analysis.

A trigger detecting means detects whether the output signal of the processing means satisfies a predetermined trigger condition. A control means controls the decelerating means according to the output signal of the trigger detecting means if the measurement frequency band of the signal under test is over said specific frequency band. In this case, the output signal of the processing means is derived from the narrow band signal processing means for detecting whether it satisfies the predetermined trigger condition. Therefore, the trigger function concerning the wide bandwidth is realized by a slight modification relative to the conventional narrow one.

### Brief Description of the Drawings

Fig. 1 shows a schematic block diagram of a conventional signal analyzer.
Fig. 2 shows a schematic block diagram of one preferred embodiment according to the present invention.

### Description of Preferred Embodiments of the Invention

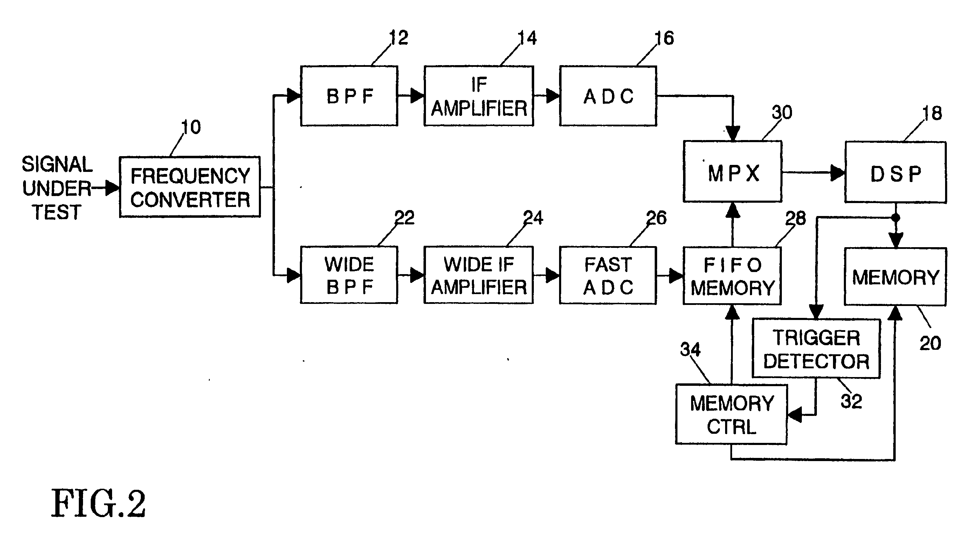

Fig. 2 shows a schematic block diagram of one preferred embodiment according to the present invention. The elements corresponding to those of Fig. 1 have the same reference symbols, respectively. A frequency converter 10 converts a signal under test into a suitable IF (Intermediate Frequency) signal. The frequency converter 10 may have a mixer and a local oscillator etc. as usual. The frequency converter 10 provides the IF signal to both band pass filter (BPF) 12 and wide band pass filter 22. The BPF 12 could be a filter similar to the conventional one as shown in Fig. 1, and has a narrow band pass width, such as 5MHz, then can be the input of a signal pass for a narrow band side. On the other hand, the wide BPF 22 has a wider bandwidth than that of the BPF 12 and can be the input of a signal pass for a wide band side. The output of the BPF 12 is connected to an IF amplifier 14 and the output of the IF amplifier 14 is connected to an ADC (Analog To Digital Converter) 16 as usual. This signal pass of the narrow band side, having the BPF 12, the IF amplifier 14 and the ADC 16, is the same as the conventional one as shown in Fig. 1.

The wide BPF 22 has a wider bandwidth, such as 30MHz. Therefore, the output signal of the wide BPF 22 has wider bandwidth and the maximum frequency is higher than that of the output signal of the BPF 12. A wide band IF amplifier 24 appropriately amplifies the output signal of the wide BPF 22 and a fast ADC 26 converts it into a digital signal. The sampling theorem as is well known to the man skilled in the art tells that the sampling frequency in the analog to digital conversion needs at least two times of the maximum frequency of the analog input signal. Then the sampling frequency of the fast ADC 26 should have two or over times of the maximum frequency of the output signal of the wide band IF amplifier 24. This leads it to that the transfer rate of the output data of the fast ADC 26 is higher than that of the ADC 16 in the narrow band side. A FIFO (First In First Out) memory 28 stores the output data of the fast ADC 26 sequentially.

The FIFO, or first in first out memory 28 provides sequential storage and read out of the data. If the FIFO memory 28 becomes full before the storage operation stops, it stores the latest data with deleting the oldest data. The FIFO memory 28, however, also works as a means for reducing the data transfer rate and makes it possible that the speed of reading the data is slower than that of the data storage. This allows that the data transfer rate of the output data of the FIFO memory 28 meets that of the ADC 16.

A multiplexer (MPX) 30 receives the output signals of both the ADC 16 and the FIFO memory 28 and works as a means for selecting one of them. A DSP (Digital Signal Processor) 18 receives the output signal of the multiplexer 30 and conducts a necessary process, such as FFT, similar to the conventional one. If the DSP 18 conducts the FFT process, it produces the frequency domain data corresponding to the output data of the multiplexer 30. A memory 20 stores the output data of the DSP 18. The data stored in the memory 20 could be used for displaying the measurement result on a display (not shown), such as CRT, or for another analysis.

The DSP 18 provides the output data to a trigger detector 32 as well as the memory 20. The trigger detector 32 compares the frequency domain data from the DSP 18 with a preset trigger condition data and generates a trigger signal if the trigger condition is satisfied. The memory controller 34 receives the trigger signal and controls the memory 20 and/or the FIFO memory 28 according to the trigger signal. In use of the analyzer, the operator selects the narrow band or wide band for measurement. If the operator selects a relatively narrow bandwidth for analysis, the memory controller 34 controls the storage operation of the memory 20 for the trigger function, and the operation is the same as that of the conventional analyzer shown in Fig. 1. The analyzer realizes the pre-trigger and post-trigger functions as described above. In this case, the FIFO memory 28 is not used.

On the contrary, if the operator selects a wider bandwidth for analysis, the memory controller 34 controls the storage operation of the FIFO memory 28, containing the digital data produced by the wide band signal processor. The memory controller 34 controls the data remaining in the FIFO memory according to the trigger function, such as pre-trigger or post-trigger function, with reference to the trigger signal generated by the trigger detector 32 based on the frequency domain data acquired by the narrow band signal processor. Then the control of the FIFO memory 28 realizes an effective event trigger operation in the wide band signal process. In this case, the memory 20 may store the data derived from the output signal of the fast ADC 26 via the DSP 18.

By the way, it is a remarkable point that the frequency domain data output from the DSP 18 for detecting a trigger event, are such data as produced by a narrow band processing means which has the BPF 12, the IF amplifier 14 and the ADC 16. In other words, the trigger detector 32 detects the trigger by using the frequency domain data acquired in the narrow band signal processing, while the memory controller 34 controls the data produced in the wide band signal process and stored in the FIFO memory 28. Therefore, it can realize the trigger function useful enough with slight modification relative to the conventional one and with the minimum cost up while it also realizes the wide band signal processing. Of course, it can also easily realize the pre-trigger and post-trigger functions as usual event trigger functions by controlling the storage operation of the FIFO memory 28.

If the FIFO memory 28 completes to store the desired data in the wide band signal processing, the multiplexer 30 selects the data read out from the FIFO memory 28 to provide them to the DSP 18. The DSP 18 transforms the data by the FFT process to produce the frequency domain data of the wide band signal process. The memory 20 stores the frequency domain data of the wide band signal process, which are used for displaying the measurement result on the CRT etc. or for another analysis.

The data previously stored in the memory 20 from the narrow band processing means may be transferred to another memory, such as a magnetic disk, if the memory 20 has insufficient capacity.

By the way, the trigger function may not be used. In this case, the data is continuously acquired from one of the narrow and wide band signal processing paths and displayed. The data derived from the wide band signal processing path, however, sometimes requires suspend time of the data acquisition because of the decelerated data output.

As described above, for the narrow bandwidth measurement, a wide band signal analyzer according to the present invention can use the construction similar to the conventional one. Therefore it does not cause the spurious characteristics worse or noise because of the wider band. Both the signal passes of the narrow and wide band sides can be constructed from the optimum devices of filters, amplifiers and ADCs, respectively, according to the measurement band so that it is favorable from technical and economical viewpoints. Because it has a means for decelerating the data transfer rate of the output data of the fast analog to digital converter, the operation speed of the DSP 18 or memory 20 can be slow, which reduces the cost increase at the minimum. It can easily realize an event trigger function in the wide band signal process with slight modification relative to the conventional one and with the minimum cost increase. It will also be apparent for the man skilled in the art that there are additional embodiments which are not described above but which are clearly within the scope and principle of the present invention, as defined in the claims.

## Claims

1. A wide band signal analyzer comprising
a frequency convarter (10) for converting a signal under test to an intermediate frequency signal having a measurement frequency band,
a narrow band signal processor (12, 14, 16) for receiving the intermediate frequency signal and producing a first digital signal representing a first frequency band of the frequency signal,
a wide band signal processor (22, 24, 26) for receiving the intermediate frequency signal and producing a second digital signal representing a second frequency band of the intermediate frequency signal,
a transfer rate decelerator (28) for decelerating a transfer rate of the second digital signal,
a digital processor (18, 30) for processing selectively the first digital signal or an output signal of the transfer rate decelerator (28),
a memory (20) for storing a processed output of the digital processor (18,30),
a trigger detector (32) for detecting whether the processed output of the digital processor (18, 30) derived from the first digital signal satisfies a predetermined trigger condition, and
a controller (34) for controlling the transfer rate decelerator (28) according to an output signal of the trigger detector (32) if the measurement frequency band of the intermediate frequency signal is wider than the first frequency band.

2. A wide band signal analyzer according to claim 1, wherein the second frequency band includes the first frequency band.

3. A wide band signal analyzer according to claim 1 or 2, wherein the transfer rate decelerator (28) comprises means for temporarily storing the second digital signal and the controller (34) is operable to adjust an interval between a time that occurrence of the trigger condition is detected and a time at which storing of the second digital signal by the transfer rate decelerator (28) terminates.

4. A wide band signal analyzer according to claim 1, wherein the digital processor (18, 30) comprises means for selectively processing the first digital signal if the measurement frequency band of the intermediate frequency signal is within said first frequency band and processing the output signal of the transfer rate decelerator (28) if the measurement frequency band of the intermediate frequency signal is wider than the first frequency band.

5. A wide band signal analyzer according to any preceding claim, wherein the narrow band signal processor (12, 14, 16) includes a band pass filter (12) for passing the first frequency band of the intermediate frequency signal, and an analog to digital converter (16) for converting an output signal of the band pass filter (12) to produce the first digital signal.

6. A wide band signal analyzer according to claim 5, wherein the narrow band signal processor (12, 14, 16) includes an intermediate frequency amplifier (14) between an output of the band pass filter (12) and an input of the analog to digital converter (16).

7. A wide band signal analyzer according to any preceding claim, wherein the wide band signal processor (22, 24, 26) includes a wide band pass filter (22) for passing the second frequency band of the intermediate frequency signal, and a fast analog to digital converter (26) for converting an output signal of the wide band pass filter (22) to produce the second digital signal.

8. A wide band signal analyzer according to claim 7, wherein the wide band signal processor (22, 24, 26) includes a wide band intermediate frequency amplifier (24) between an output of the wide band pass filter (22) and an input of the fast analog to digital converter (26).

9. A wide band signal analyzer according to any preceding claim, wherein the transfer rate decelerator includes a FIFO memory (28) for sequentially storing the output signal of the wide band signal processor (22, 24, 26), of which a read out rate is slower than a storage rate.

10. A wide band signal analyzer according to any preceding claim, wherein the digital processor (18, 30) comprises means for performing an FFT process for producing frequency domain data of the selected first digital signal or output signal of the transfer rate decelerator (28).

11. A wide band signal analyzer according to any preceding claim, wherein the transfer rate decelerator (28) comprises means for temporarily storing the second digital signal and if the transfer rate decelerator (28) becomes full before the storage operation terminates,storing most recent data and deleting oldest data.

12. A wide band signal analyzer according to any preceding claim, wherein the digital processor (18, 30) includes a selector (30) for selecting the first digital signal or the output signal of the transfer rate decelerator (28) and a digital signal processor (18) for processing the signal selected by the selector (30).

## Patentansprüche

1. Breitbandsignalanalysator, der folgendes umfasst:
einen Frequenzumsetzer (10) zum Umsetzen eines getesteten Signals in ein Zwischenfrequenzsignal mit einem Messfrequenzband;
einen Schmalbandsignalprozessor (12, 14, 16) zum Empfangen des Zwischenfrequenzsignals und zum Erzeugen eines ersten digitalen Signals, das ein erstes Frequenzband des Zwischenfrequenzsignals darstellt;
einen Breitbandsignalprozessor (22, 24, 26) zum Empfangen des Zwischenfrequenzsignals und zum Erzeugen eines zweiten digitalen Signals, das ein zweites Frequenzband des Zwischenfrequenzsignals darstellt;
eine Übertragungsraten-Verzögerungseinrichtung (28) zum Verlangsamen einer Übertragungsrate des zweiten digitalen Signals;
einen digitalen Prozessor (18, 30) zum selektiven Verarbeiten des ersten digitalen Signals oder eines Ausgangssignals der Übertragungsraten-Verzögerungseinrichtung (28);
einem Speicher (20) zum Speichern einer verarbeiteten Ausgabe des digitalen Prozessors (18, 30);
einen Auslösedetektor (32) zum Detektieren, ob die von dem ersten digitalen Signal abgeleitete verarbeitete Ausgabe des digitalen Prozessors (18, 30) einen vorbestimmten Auslösezustand erfüllt; und
eine Steuereinheit (34) zum Steuern der Übertragungsraten-Verzögerungseinrichtung (28) gemäß einem Ausgangssignal des Auslösedetektors (32), wenn das Messfrequenzband des Zwischenfrequenzsignals breiter ist als das erste Frequenzband.

2. Breitbandsignalanalysator nach Anspruch 1, wobei das zweite Frequenzband das erste Frequenzband aufweist.

3. Breitbandsignalanalysator nach Anspruch 1 oder 2, wobei die übertragungsraten-Verzögerungseinrichtung (28) eine Einrichtung zum temporären Speichern des zweiten digitalen Signals umfasst, und wobei die Steuereinheit (34) so funktionsfähig ist, dass ein Intervall zwischen dem Zeitpunkt des Feststellens des Auftretens des Auslösezustands und dem Zeitpunkt, zu dem das Speichern des zweiten digitalen Signals durch die Übertragungsraten-Verzögerungseinrichtung (28) endet, angepasst wird.

4. Breitbandsignalanalysator nach Anspruch 1, wobei der digitale Prozessor (18, 30) eine Einrichtung zum selektiven Verarbeiten des ersten digitalen Signals umfasst, wenn sich das Messfrequenzband des Zwischenfrequenzsignals innerhalb des genannten ersten Frequenzbandes befindet, und wobei das Ausgangssignal der Übertragungsraten-Verzögerungseinrichtung (28) verarbeitet wird, wenn das Messfrequenzband des Zwischenfrequenzsignals breiter ist als das erste Frequenzband.

5. Breitbandsignalanalysator nach einem der vorstehenden Ansprüche, wobei der Schmalbandsignalprozessor (12, 14, 16) einen Bandpassfilter (12) zum Durchlassen des ersten Frequenzbands des Zwischenfrequenzsignals aufwiest, und mit einem Analog-Digital-Umsetzer (16) zum Umsetzen eines Ausgangssignals des Bandpassfilters (12), so dass das erste digitale Signal erzeugt wird.

6. Breitbandsignalanalysator nach Anspruch 5, wobei der Schmalbandsignalprozessor (12, 14, 16) einen Zwischenfrequenzverstärker (14) zwischen einem Ausgang des Bandpassfilters (12) und einem Eingang des Analog-Digital-Umsetzers aufweist.

7. Breitbandsignalanalysator nach einem der vorstehenden Ansprüche, wobei der Breitbandsignalprozessor (22, 24, 26) einen Breitbandpassfilter (22) zum Durchlassen des zweiten Frequenzbands des Zwischenfrequenzsignals aufweist sowie einen schnellen Analog-Digital-Umsetzer (26) zum Umsetzen eines Ausgangssignals des Breitbandpassfilters (22), so dass das zweite digitale Signal erzeugt wird.

8. Breitbandsignalanalysator nach Anspruch 7, wobei der Breitbandsignalprozessor (22, 24, 26) einen Breitband-Zwischenfrequenzverstärker (24) zwischen einem Ausgang des Breitbandpassfilters (22) und einem Eingang des schnellen Analog-Digital-Umsetzers (26) aufweist.

9. Breitbandsignalanalysator nach einem der vorstehenden Ansprüche, wobei die Übertragungsraten-Verzögerungseinrichtung einen FIFO-Speicher (28) zum sequentiellen Speichern des Ausgangssignals des Breitbandsignalprozessors (22, 24, 26) aufweist, dessen Ausleserate langsamer ist als eine Speicherrate.

10. Breitbandsignalanalysator nach einem der vorstehenden Ansprüche, wobei der digitale Prozessor (18, 30) eine Einrichtung zum Ausführen eines FFT-Prozesses zum Erzeugen von Frequenzbereichsdaten des ausgewählten ersten digitalen Signals oder des Ausgangssignals der übertragungsraten-Verzögerungseinrichtung (28) umfasst.

11. Breitbandsignalanalysator nach einem der vorstehenden Ansprüche, wobei die Übertragungsraten-Verzögerungseinrichtung (28) eine Einrichtung zum temporären Speichern des zweiten digitalen Signals umfasst, und wenn die übertragungsraten-Verzögerungseinrichtung (28) voll wird, bevor der Speichervorgang endet, werden die letzten Daten gespeichert und die ältesten Daten gelöscht.

12. Breitbandsignalanalysator nach einem der vorstehenden Ansprüche, wobei der digitale Prozessor (18, 30) eine Auswahleinrichtung (30) zur Auswahl des ersten digitalen Signals oder des Ausgangssignals der Übertragungsraten-Verzögerungseinrichtung (28) aufweist, und mit einem digitalen Signalprozessor (18) zur Verarbeitung des durch die Auswahleinrichtung (30) ausgewählten Signals.

## Revendications

1. Analyseur de signal à large bande comprenant :
un convertisseur de fréquence (10) pour convertir un signal soumis aux essais en un signal à fréquence intermédiaire ayant une bande de fréquences de mesure,
un processeur de signal à bande étroite (12, 14, 16) pour recevoir le signal à fréquence intermédiaire et produire un premier signal numérique représentant une première bande de fréquences du signal à fréquence intermédiaire,
un processeur de signal à large bande (22, 24, 26) pour recevoir le signal à fréquence intermédiaire et produire un second signal numérique représentant une seconde bande de fréquences du signal à fréquence intermédiaire,
un décélérateur de vitesse de transfert (28) pour décélérer une vitesse de transfert du second signal numérique,
un processeur numérique (18, 30) pour traiter sélectivement le premier signal numérique ou un signal de sortie du décélérateur de vitesse de transfert (28),
une mémoire (20) pour stocker une sortie traitée du processeur numérique (18, 30),
un détecteur de déclenchement (32) pour détecter si la sortie traitée du processeur numérique (18, 30) dérivée du premier signal numérique satisfait une condition de déclenchement prédéterminée, et
un contrôleur (34) pour contrôler le décélérateur de vitesse de transfert (28) selon un signal de sortie du détecteur de déclenchement (32) si la bande de fréquences de mesure du signal à fréquence intermédiaire est plus large que la première bande de fréquences.

2. Analyseur de signal à large bande selon la revendication 1, dans lequel la seconde bande de fréquences comprend la première bande de fréquences.

3. Analyseur de signal à large bande selon la revendication 1 ou 2, dans lequel le décélérateur de vitesse de transfert (28) comprend des moyens pour stocker provisoirement le second signal numérique et le contrôleur (34) est actionnable pour régler un intervalle entre un temps où l'occurrence de la condition de déclenchement est détectée et un temps auquel le stockage du second signal numérique par le décélérateur de vitesse de transfert (28) se termine.

4. Analyseur de signal à large bande selon la revendication 1, dans lequel le processeur numérique (18, 30) comprend des moyens pour sélectivement traiter le premier signal numérique si la bande de fréquences de mesure du signal à fréquence intermédiaire est dans ladite première bande de fréquences et pour traiter le signal de sortie du décélérateur de vitesse de transfert (28) si la bande de fréquences de mesure du signal à fréquence intermédiaire est plus large que la première bande de fréquences.

5. Analyseur de signal à large bande selon l'une quelconque des revendications précédentes, dans lequel le processeur de signal à bande étroite (12, 14, 16) comprend un filtre passe-bande (12) pour passer la première bande de fréquences du signal à fréquence intermédiaire, et un convertisseur analogique/numérique (16) pour convertir un signal de sortie du filtre passe-bande (12) afin de produire le premier signal numérique.

6. Analyseur de signal à large bande selon la revendication 5, dans lequel le processeur de signal à bande étroite (12, 14, 16) comprend un amplificateur de fréquence intermédiaire (14) entre une sortie du filtre passe-bande (12) et une entrée du convertisseur analogique/numérique (16).

7. Analyseur de signal à large bande selon l'une quelconque des revendications précédentes, dans lequel le processeur de signal à large bande (22, 24, 26) comprend un filtre passe-bande large (22) pour passer la seconde bande de fréquences du signal à fréquence intermédiaire, et un convertisseur analogique/numérique rapide (26) pour convertir un signal de sortie du filtre passe-bande large (22) afin de produire le second signal numérique.

8. Analyseur de signal à large bande selon la revendication 7, dans lequel le processeur de signal à large bande (22, 24, 26) comprend un amplificateur de fréquence intermédiaire à large bande (24) entre une sortie du filtre passe-bande large (22) et une entrée du convertisseur analogique/numérique rapide (26).

9. Analyseur de signal à large bande selon l'une quelconque des revendications précédentes, dans lequel le décélérateur de vitesse de transfert comprend une mémoire FIFO (28) pour stocker séquentiellement le signal de sortie du processeur de signal à large bande (22, 24, 26), dont une vitesse de lecture est plus lente qu'une vitesse de stockage.

10. Analyseur de signal à large bande selon l'une quelconque des revendications précédentes, dans lequel le processeur numérique (18, 30) comprend des moyens pour réaliser un processus FFT afin de produire des données de domaine de fréquence du premier signal numérique sélectionné ou signal de sortie du décélérateur de vitesse de transfert (28).

11. Analyseur de signal à large bande selon l'une quelconque des revendications précédentes, dans lequel le décélérateur de vitesse de transfert (28) comprend des moyens pour temporairement stocker le second signal numérique et si le décélérateur de vitesse de transfert (28) devient plein avant la fin de l'opération de stockage, pour stocker les plus récentes données et supprimer les plus anciennes données.

12. Analyseur de signal à large bande selon l'une quelconque des revendications précédentes, dans lequel le processeur numérique (18, 30) comprend un sélecteur (30) pour sélectionner le premier signal numérique ou le signal de sortie du décélérateur de vitesse de transfert (28) et un processeur de signal numérique (18) pour traiter le signal sélectionné par le sélecteur (30).
